# EUROPEAN PATENT SPECIFICATION

(11) **EP 1 887 614 B1**
(45) Date of publication and mention of the grant of the patent: **11.08.2010**
(21) Application number: 05751409.3
(22) Date of filing: 03.06.2005
(51) Int. Cl.: H01L 21/027, G03F 7/20

(54) **PATTERNING METHOD**
STRUKTURIERUNGSVERFAHREN
PROCEDE DE MISE EN MOTIF

(43) Date of publication of application: 13.02.2008
(73) Proprietor: ADVANTEST CORPORATION, Tokyo 179-0071 (JP)
(72) Inventor: MITA, Yoshio, c/o TOKYO UNIVERSITY, Tokyo 113-8656 (JP); BOUROUINA, Tarik, c/o Ecole Sup. d'Ing. en Elec. & Electrotechn., BP 99, 93162 Noisy le Grand CEDEX (FR); MARTY, Federic, Ecole Sup. d'Ing. en Electr. & Electrotechn., BP 99, 93162 Noisy le Grand CEDEX (FR)
(74) Representative: Tetzner, Michael
(86) International application number: PCT/JP2005/010272
(87) International publication number: WO 2006/129374

(56) References cited:
- EP-A- 0 111 707
- WO-A-83/03485
- JP-A- 3 127 818
- JP-A- 5 152 199
- JP-A- 55 056 629
- JP-A- 59 117 214
- JP-A- 63 197 333
- R C HENDERSON, J G NASH: "Short channel n-MOS devices via combined e-beam and photolithographic processing" J. VAC. SCI. TECHNOL., vol. 16, no. 6, 1979, pages 1654-1657, XP002503594

## Description

### BACKGROUND OF THE INVENTION

### 1. Field of the Invention

The present invention relates to a method of patterning a structure with a first opening and a second opening smaller than the first opening.

### 2. Description of the Prior Art

In manufacturing a semiconductor integrated circuit or micromachining, a desired structure is manufactured by repeating the steps of: "exposure" by which a design pattern is printed on a substrate; and "etching" by which a film is formed on the substrate according to the pattern thus printed.

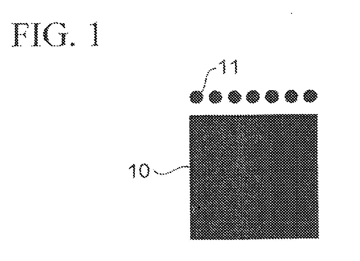

Generally, a semiconductor device, or a micromachine, has fine structures mixed with structures provided to interface with the outside and each having a large area. For example, as shown in FIG. 1, small openings 11 are mixed with a large opening 10.

To form the fine structure, such as a hole with a diameter of 1 µm or less, an electron-beam (EB) exposure system capable of performing accurate exposure is used in the exposure process. Accordingly, a possible way of patterning accurately a design pattern including a fine structure is exposing the entire design pattern solely with an EB exposure system.

However, the use of the EB exposure for exposing the large opening 10 enables accurate exposure, but the exposure is time-consuming.

For such a problem, for example, a Mix-and-Match method is proposed by J. Yeom, Y. Wu, and M. A. Shannon, "Critical Aspect Ratio Dependence in Deep Reactive Ion Etching of Silicon," in The 12th International Conference on Solid-State Sensors, Actuators and Microsystem (Transducers '03), vol. 2, Boston, U.S.A., June 2003, pp. 1631-1634. In the method, both the photolithography and electron-beam lithography are used. A large opening is written with a high-speed exposure system such as a stepper, and thereafter the electron-beam lithography is performed using an EB exposure system.

As described above, in the Mix-and-Match method, the large opening is exposed to light, while the small opening is exposed to electron beams. Accordingly, when the writing is performed on a layer provided with a large opening and a small opening existing thereon together, even the Mix-and-Match method leaves the following problems unsolved.

Specifically, when the small opening and the large opening are exposed separately, the positions of the openings need to be aligned. At this time, the alignment accuracy between the small opening and the large opening depends on a system. For example, in a general system such as a mask aligner, the alignment accuracy is approximately 1 µm at most.

Moreover, since the photolithography is used for a large opening, the large opening is generally inferior to an opening directly written with electron beams in terms of accuracy at the time of production. Thus, it is difficult to form a large opening accurately.

Furthermore, the etching condition generally depends on the size of an opening. Accordingly, it is not easy to find out the condition where a large opening and a small opening can be etched simultaneously. Rather, the condition where the etching can be performed simultaneously does not exist in many cases.

EP 0 111 707 A2 relates to a method of forming exposure patterns by forming the edge part of a complete pattern with electron beam radiation and forming the remaining part with light radiation.

### SUMMARY OF THE INVENTION

The present invention has been made in view of the aforementioned problems of the prior art. An object of the present invention is to provide a method of patterning a structure having both a large opening and a small opening accurately at a high speed.

This object is solved by the features of claim 1.

In the present invention, the large opening (first opening) is divided into a "contour part" (a band-like opening with a predetermined width including the contour of the first opening) and a "remaining part of the large opening" obtained by excluding the contour part.

And the exposure and etching process is performed in two stages. In other words, the small opening (second opening) and the "contour region" are processed at once by a precise exposure method such as an electron-beam exposure system, and the "remaining part of the large opening" is processed by a photolithography method. Thus, the precise writing is performed only on the small opening and the contour region of the large opening, resulting in a great reduction in the exposure time. Additionally, the small opening and the contour region of the large opening are written at once by a single system, making it possible to accurately perform the alignment between the small opening and the large opening. Moreover, the small opening and the remaining part of the large opening can be etched separately, allowing each of the openings to be etched under the optimum etching condition. Furthermore, since the contour region of the large opening is written precisely, the large opening is formed accurately.

Specifically, this method is to pattern a layer provided on a substrate and includes the steps of: forming a silicon nitride film on a film to be patterned; coating the upper surface of the silicon nitride film with a photoresist, and performing an exposure and development process on the photoresist thereby to form a first resist pattern which delimits the shape formed by excluding, from the first opening, a band-like opening with a predetermined width including the contour of the first opening; patterning the silicon nitride film using the first resist pattern as a mask; coating the upper surface of the film to be patterned with an electron-beam resist after the silicon nitride film is patterned; exposing the electron-beam resist to electron beams and performing a development process thereon to form a second resist pattern which delimits the shapes of the band-like opening and of the second opening; etching the film to be patterned using the second resist pattern as a mask to form the band-like opening and the second opening; removing the second resist pattern, and thereafter thermally oxidizing the surface of the film to be patterned thereby to form a silicon oxide film; etching the silicon nitride film and the film to be patterned below the silicon nitride film, after the thermal oxidation, thereby to form an opening obtained by excluding the band-like opening from the first opening; and removing the silicon oxide film.

According to the invention, local oxidation of silicon (LOCOS) is utilized to form the small opening (second opening) and the contour part (band-like opening) of the large opening (first opening). Thereafter, the silicon oxide film is formed on the side walls of the small openings, and the like, by the thermal oxidation. Thereby, when the large opening is formed by etching the silicon nitride film and the silicon after the above steps, a step to form a new protection film is saved.

### BRIEF DESCRIPTION OF THE DRAWINGS

FIG. 1 shows an example of a pattern having a large opening and small openings.
FIG. 2A to FIG. 2E illustrate an outline of patterning methods according to the present invention.
FIG. 3 shows an example of a pattern to be formed by the patterning methods according to the present invention.
FIG. 4A to FIG. 4C are cross-sectional views (Part 1) showing a patterning method.
FIG. 5A to FIG. 5C are cross-sectional views (Part 2) showing the patterning method.
FIG. 6 shows the comparison between an exposure time using the patterning method according to Fig. 4A to 5C and an exposure time using electron-beam exposure.
FIG. 7A and FIG. 7B show an example of a pattern having a large doughnut-shaped opening and small openings.
FIG. 8A to FIG. 8C are cross-sectional views (Part 1) showing the patterning method according to the present invention.
FIG. 9A to FIG. 9C are cross-sectional views (Part 2) showing the patterning method according to the present invention.

### DESCRIPTION OF THE PREFERRED EMBODIMENTS

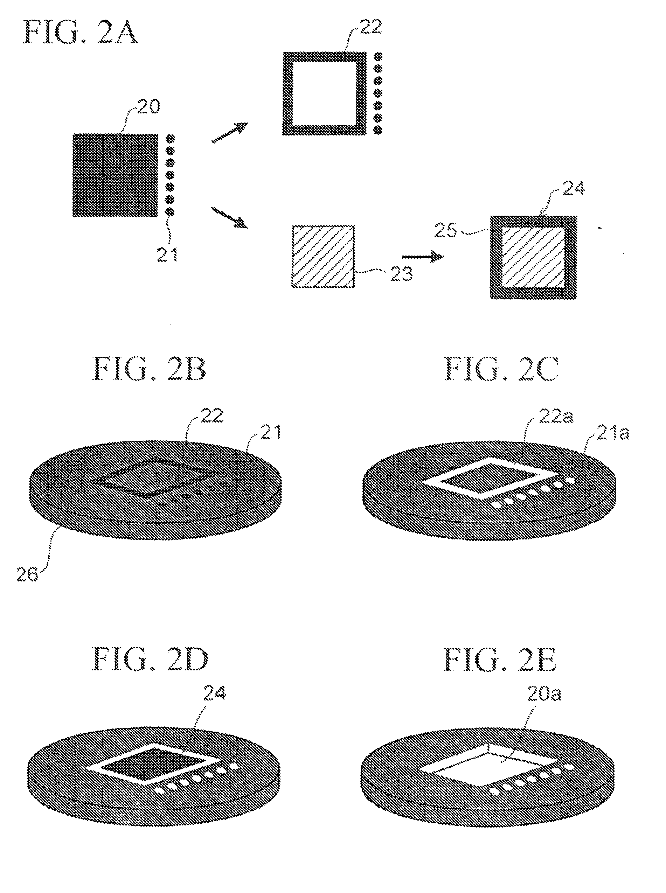

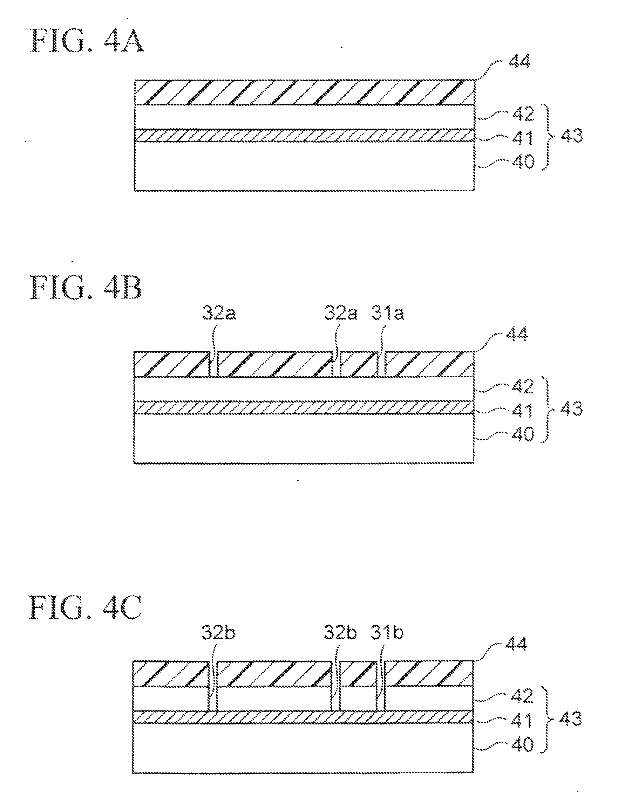

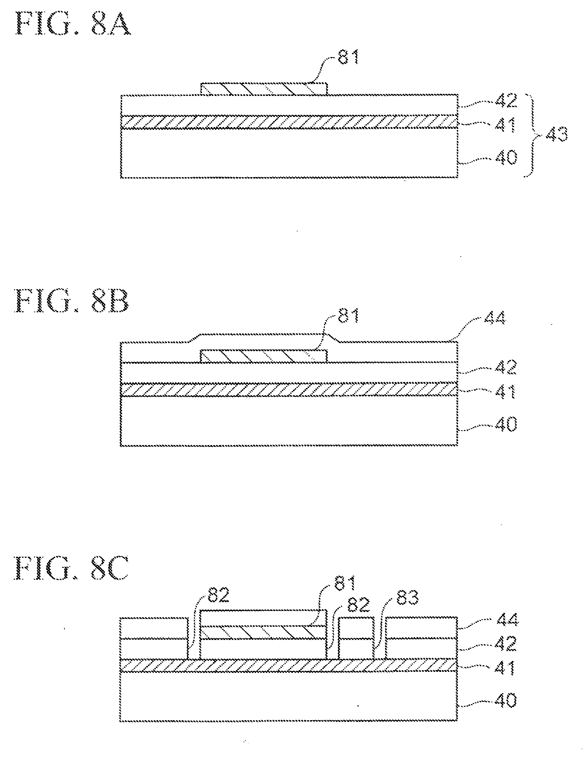

First of all, an outline of patterning methods will be described (Fig. 2A to 3). Then, patterning methods will be described in order of manufacturing steps in a first embodiment (Fig. 4A to 6) which is not part of the invention and a second embodiment (Fig. 8A to 9C) according to the invention.

FIG. 2A to FIG. 2E illustrate the outline of the patterning methods. A design pattern to be formed in the embodiments is shown on the left side of FIG. 2A. The pattern mixedly including a large opening 20 and smaller openings 21 is divided into two parts: one is a part consisting of the smaller openings 21 and a contour part 22 of the large opening 20; and the other is a part 23 obtained by excluding the contour part 22 from the large opening 20. Additionally, a margin 25 is added to the periphery of the part (remaining part) 23 obtained by excluding the contour part 22 from the large opening 20.

In order to form the small openings 21 and the contour part 22 on an SOI (Silicon on Insulator) wafer 26 as shown in FIG. 2B, the wafer 26 is exposed to electron beams and etched, and thereby openings 21a and 22a are formed as shown in FIG. 2C.

Thereafter, in order to form a part 24 obtained by adding the margin 25 to the remaining part 23 as shown in FIG. 2D, the wafer 26 is exposed to light and etched, and thereby an opening 20a is formed as shown in FIG. 2E.

As described above, the pattern is formed by dividing the design pattern into two, and.by changing the exposure method and etching condition in accordance with the size of openings.

The present invention is a method of patterning a structure having a large opening and a small opening as described above. The present invention is useful particularly for a structure having a large opening in a size of millimeter to centimeter and a small opening in a size of submicron to nanometer.

### First embodiment

Description will be given below of the patterning method according to the first embodiment not forming part of the invention in order of manufacturing steps.

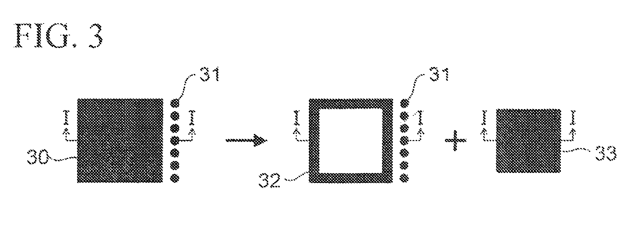

Here, in a pattern to be formed, a large opening 30 and small openings 31 are mixedly included as shown in FIG. 3. One side of the large opening 30 is 20 µm, while the diameter of the small opening 31 is 1 µm.

Firstly, the pattern (30 and 31) shown on the left side of FIG. 3 is divided into: the small openings 31 and a contour part 32; and a part 33 obtained by excluding the contour part 32 from the large opening 30 and by adding a predetermined margin. Here, the size of the contour part 32 is set approximately the same as that of the small opening 31, and accordingly the width of the contour part 32 is for example 5 µm.

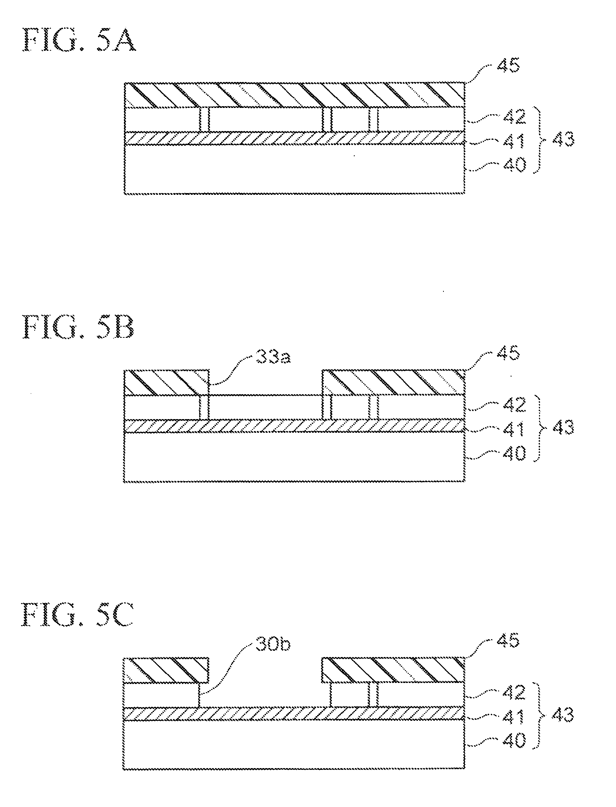

FIG. 4A to FIG. 4C and FIG. 5A to FIG. 5C are cross-sectional views showing the patterning method according to the first embodiment in order of manufacturing steps. The views are cross-sectional views along the I-I line in FIG. 3.

At first, as shown in FIG. 4A, an SOI wafer 43 is formed. The SOI wafer 43 has a structure in which a silicon oxide film 41 is sandwiched between a silicon substrate 40 and a silicon thin-film 42 to be a structural layer. For example, this silicon thin-film 42 to be the structural layer is formed to have a thickness of 3 µm.

The entire upper surface of this SOI wafer 43 is coated with an electron-beam (EB) resist 44. As the EB resist, for example, ZEP-520A manufactured by Zeon Corporation is used.

Next, as shown in FIG. 4B, a pattern which delimits the shapes of a small opening 31a and of a contour part 32a of a large opening is formed by exposing the EB resist by means of an electron-beam (EB) exposure system and then by performing a development process.

Subsequently, the small opening and the contour part of the large opening are etched using the EB resist 44 as a mask to form openings (31b and 32b) as shown in FIG. 4C. In this etching process, for example, a sulfur hexafluoride gas (SF₆) is used and plasmatized with an inductively coupled plasma (ICP), and thus a deep reactive ion etching (DRIE) is performed. Meanwhile, a Bosch process may be performed, in which the etching is performed rapidly while gases of SF₆ and C₄F₈ are alternatively used.

Thereafter, as shown in FIG. 5A, the SOI wafer 43 is coated with a photoresist 45 by a spin coating method. As the photoresist 45, for example, S1805 manufactured by Shipley Company, LLC., is used.

After that, as shown in FIG. 5B, an exposure and development process in a photolithography method is performed on the part 33 obtained by adding the margin to the remaining part of the large opening to form a resist pattern which delimits the shape formed by adding the margin to the remaining part of the large opening.

Then, as shown in FIG. 5C, by using the formed resist pattern shown in FIG. 5B as a mask, the silicon film to be the structural layer is etched to form a large opening 30b. At this time, the previously-formed small opening 31 b is protected by the photoresist 45. This etching is performed using the same ICP-DRIE system as that used in FIG. 4C.

Subsequently, the photoresist 45 is removed.

As described above, in this embodiment, the large opening is divided into the "contour part" and the remaining part obtained by excluding the contour part, and then the exposure and etching process is performed in two stages. In other words, small openings and the "contour part" are processed at once by the precise exposure method like the electron-beam exposure system, and thereafter the remaining large opening is processed. Thus, the precise writing is performed only on the small openings and the contour part of the large opening. As a result, the exposure time is greatly reduced.

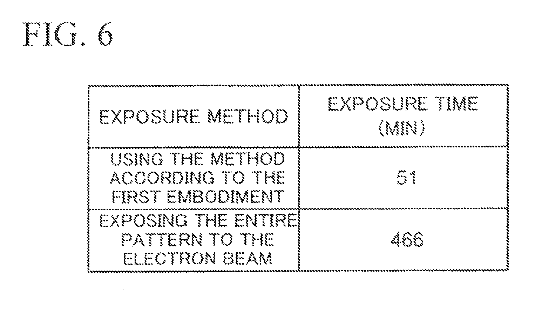

FIG. 6 shows the comparison between the exposure time when the exposure was performed by exposing the entire pattern shown in FIG. 3 to the electron beams and the exposure time when the exposure was performed using the method according to this embodiment. According to this embodiment, the exposure achieves approximately 9 times faster than the case where the entire pattern is exposed to the electron beams, as shown in FIG. 6.

Moreover, the small openings and the contour part of the large opening are written simultaneously by the same system. As a result, the alignment is performed accurately. Furthermore, since the small openings and the large opening are etched separately, each opening is etched under the optimum condition.

Note that, in this embodiment, the method of forming the pattern using a SOI wafer has been described, but the wafer to be used is not limited to a SOI wafer.

Additionally, in this embodiment, the case has been described where the thickness of the silicon film 42 to be the structural layer is 3 µm. However, this embodiment is not limited to this. For example, the method according to the present invention is actually used in a case where the thickness of the silicon film 42 is 70 µm and it has been confirmed that by use of this method the pattern is formed accurately at a high speed also in this case. However, in this case, it should be noted that, since the depth of the openings is large, the photoresist film is not properly formed with a standard-type photoresist as used in this embodiment, and accordingly the small openings cannot be protected. For this reason, aluminum deposited by a lift-off method is used as a mask. Specifically, after the shape of the large opening is patterned using a dry-film photoresist, a film of the aluminum is formed. Subsequently, the resist is removed while the aluminum is left only on the top of the small openings. Then, the silicon film is etched to form the large opening.

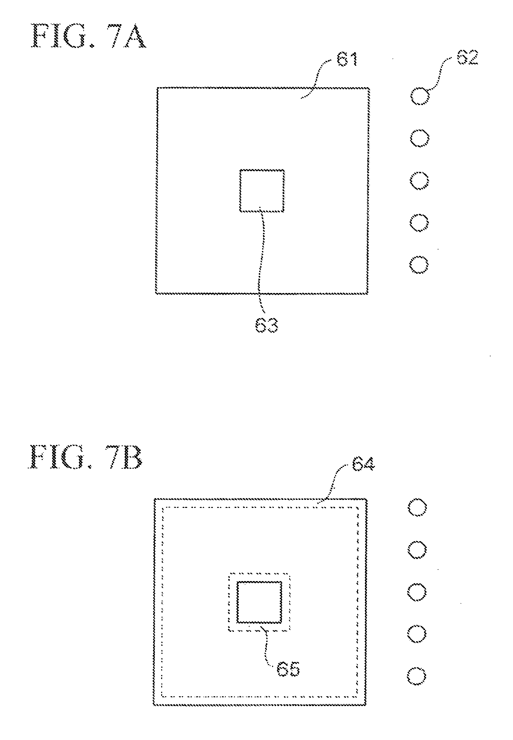

Furthermore, in this embodiment, the case has been described where the large opening is patterned so that the inside thereof is completely cleared, as shown in FIG. 3. However, this embodiment is not limited to this. For example, this embodiment can be employed for a case of patterning a large doughnut-shaped opening 61 having an unopened part 63 therein as shown in FIG. 7A. In this case, parts (64 and 65) shown by the dashed lines in FIG. 7B is regarded as the contour part of the large opening and this contour part of the large opening can be patterned simultaneously with small openings 62.

### Second embodiment

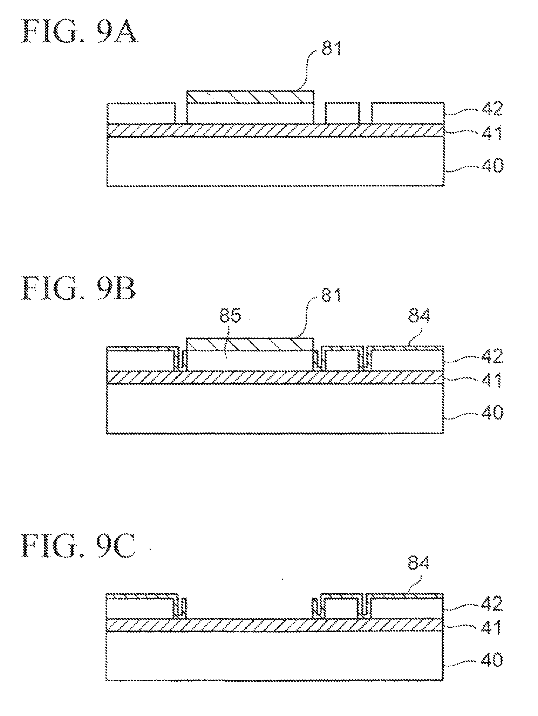

FIG. 8A to FIG. 8C and FIG. 9A to FIG. 9C are cross-sectional views showing the patterning method according to the embodiment of the present invention in order of steps.

In the first embodiment, the small openings and the contour part of the large opening are formed firstly. Then, the remaining part of the large opening is formed.

In the second embodiment, "the remaining part of a large opening" is written firstly. After small openings and the contour part of the large opening are formed, a part of silicon film corresponding to the remaining part of the large opening is etched.

Hereinafter, this patterning method will be described with reference to FIG. 8A to FIG. 9C.

The pattern shown in FIG. 3 is formed as in the case of the first embodiment. Firstly, a silicon nitride (Si₃N₄) film 81 is formed on the SOI wafer 43 as shown in FIG 8A. The silicon nitride film 81 has a shape formed by excluding the contour part of the large opening from the large opening, and is formed as follows for example. The entire upper surface of the SOI wafer 43 is reacted with, for example, a silane (SiH₄) gas and an ammonia (NH₃) gas, and the silicon nitride film 81 is formed on the remaining part of the large opening. Subsequently, the silicon nitride film 81 is coated with a photoresist, and an exposure and development process is performed on the photoresist to form a resist pattern which delimits the shape formed by excluding the contour part of the large opening from the large opening. Then, the silicon nitride film 81 is patterned.

Thereafter, the entire upper surface of this SOI wafer 43 is coated with the EB resist 44 as shown in FIG. 8B. As the EB resist, for example, ZEP-520A manufactured by Zeon Corporation is used.

After that, a pattern which delimits the shapes of the small openings and of the contour part of the large opening is formed as shown in FIG. 8C by exposing the EB resist by means of an electron-beam (EB) exposure system and then by performing a development process. Then, the silicon film 42 to be the structural layer is etched using the EB resist 44 as a mask to form openings (82 and 83). This etching process is performed by using, for example, the Bosch process and the ICP-DRIE, as in the case of the first embodiment.

Subsequently, the EB resist 44 is removed as shown in FIG. 9A. Thereafter, the SOI wafer 43 is thermally oxidized so that the part of the surface of the SOI wafer 43 which is not covered by the silicon nitride film 81 is locally oxidized as shown in FIG. 9B. Thereby, a silicon oxide film 84 is formed on the side walls and bottoms of the small openings and the contour part of the large opening as well as on the top of the silicon film 42 on which the silicon nitride film 81 is not formed.

Then, the silicon nitride film 81 and a structural layer part 85 corresponding to the remaining part of the large opening are etched to form an opening as shown in FIG. 9C. For example, the silicon nitride film 81 is etched with hot phosphoric acid, and subsequently, the silicon film of the structural layer is etched with nitric acid, and removed. During this etching, the small openings and the contour part are protected by the silicon oxide film 84.

Thereafter, the silicon oxide film 84 is removed with, for example, hydrofluoric acid.

As has been described, in this embodiment as well, the small openings and the contour part of the large opening are separated from the remaining part of the large opening, and the exposure and etching process is performed in two stages. Thus, the same effect as the first embodiment can be obtained.

Moreover, in this embodiment, the local oxidation of silicon (LOCOS) method is utilized to form the small openings (second openings) and the contour part (a band-like opening) of the large opening (first opening). Thereafter, the silicon oxide film is formed on the side walls of the small openings and the like by the thermal oxidation. Thereby, when the large opening is formed by etching the silicon nitride film and the silicon after the small openings and the like are formed, the task to form a new protection film is saved.

## Claims

1. A method of forming a pattern in a silicon film (42), the pattern including a first opening and a second opening being distinct from each other, the second opening being smaller than the first opening, and the first opening consisting of a contour part forming the boundary of the first opening and a remaining part being the part of the first opening defmed by excluding the contour part from the first opening, the method comprising the steps of:
- forming a silicon nitride film (81) on the silicon film (42) to be patterned;
- coating the upper surface of the silicon nitride film (81) with a photoresist;
exposing the photoresist to light and performing a development process to form a first resist pattern covering the portion of the silicon nitride film where the remaining part of the first opening is to be formed;
- patterning the silicon nitride film (81) using the first resist pattern as a mask so as to leave silicon nitride only where the remaining part of the first opening is to be formed, the first resist pattern being smaller than the first opening, and being larger than the remaining part of the first opening;
- coating the upper surface of the silicon film (42) to be patterned and the patterned silicon nitride film (81) with an electron-beam resist (44);
- exposing the electron-beam resist (44) to electron beams and performing a development process thereon to form a second resist pattern (44) having an opening which defines only the contour part of the first opening (82) and having a second opening (83);
- etching the silicon film (42) to be patterned using the second resist pattern (44) as a mask to form the contour part of the first opening (82) and the second opening (83);
- removing the second resist pattern (44), and thereafter thermally oxidizing the surface of the silicon film (42) to be patterned thereby to form a silicon oxide film (84);
- etching the silicon nitride film (81) and the silicon film (42) to be patterned below the silicon nitride film (81), after the thermal oxidation, thereby to form the remaining part of the first opening; and
- removing the silicon oxide film (84).

2. The patterning method according to claim 1, wherein the second resist pattern (44) is formed at once using a single electron-beam exposure system.

## Patentansprüche

1. Verfahren zur Ausbildung einer Struktur in einem Siliziumfilm (42), wobei das Muster eine erste Aussparung und eine zweite Aussparung enthält, die sich voneinander unterscheiden, wobei die zweite Aussparung kleiner ist als die erste Aussparung und die erste Aussparung aus einem die Begrenzung der ersten Aussparung bildenden Konturteil und einem verbleibenden Teil besteht, der der Teil ist, der durch Ausnehmen des Konturteils aus der ersten Öffnung definiert ist, wobei das Verfahren die folgenden Schritte umfasst:
- Bilden eines Siliziumnitridfilms (81) auf dem zu strukturierenden Siliziumfilms (42),
- Beschichten der oberen Oberfläche des Siliziumnitridfilms (81) mit einem Photolack, Bestrahlen des Photolacks mit Licht und Ausführen eines Entwicklungsprozesses, um ein erstes Photolackmuster auszubilden, das den Teilbereich des Siliziumnitridfilms abdeckt, in dem der verbleibende Teil der ersten Aussparung ausgebildet werden soll,
- Strukturieren des Siliziumnitridfilms (81) unter Verwendung des ersten Photolackmusters als eine Maske, so dass Siliziumnitrid nur dort belassen wird, wo der verbleibende Teil der ersten Aussparung ausgebildet werden soll, wobei das erste Photolackmuster kleiner ist als die erste Aussparung und größer ist als der verbleibende Teil der ersten Aussparung,
- Beschichten der oberen Oberfläche des zu strukturierenden Siliziumfilms (42) und des strukturierten Siliziumnitridfilms (81) mit einem Elektronenstrahl-Photolack (44),
- Bestrahlen des Elektronenstrahl-Photolacks (44) mit Elektronenstrahlen und Ausführen eines Entwicklungsprozesses darauf, um ein zweites Photolackmuster (44) auszubilden, das eine nur den Konturteil der ersten Öffnung (82) definierenden Aussparung aufweist und eine zweite Aussparung (83) aufweist;
- Ätzen des unter Verwendung des zweiten Photolackmusters (44) als Maske zu strukturierenden Siliziumfilms (42), um den Konturteil der ersten Aussparung (82) und der zweiten Aussparung (83) auszubilden,
- Entfernen des zweiten Photolackmusters (44) und danach thermisch Oxidieren der Oberfläche des zu strukturierenden Siliziumfilms (42), um **dadurch** einen Siliziumdioxidfilm (84) auszubilden,
- Ätzen des Siliziumnitridfilms (81) und des unter dem Siliziumnitridfilm (81) zu strukturierenden Siliziumfilms (42) nach der thermischen Oxidation, um **dadurch** den verbleibenden Teil der ersten Aussparung auszubilden, und
- Entfernen des Siliziumdioxidfilms (84).

2. Strukturierungsverfahren nach Anspruch 1, bei dem das zweite Photolackmuster (44) auf einmal unter Verwendung eines einzigen Elektronenstrahl-Belichtungssystems ausgebildet wird.

## Revendications

1. Procédé de formation d'un motif dans un film en silicium (42), le motif comprenant un premier orifice et un deuxième orifice, distincts l'un de l'autre, le deuxième orifice étant plus petit que le premier orifice, et le premier orifice consistant en une partie de contour formant la limite du premier orifice et une partie restante, qui est la partie du premier orifice définie en ôtant la partie de contour du premier orifice, le procédé comprenant les étapes consistant à
- former un film en nitrure de silicium (81) sur le film en silicium (42) sur lequel un motif doit être formé ;
- enduire la surface supérieure du film en nitrure de silicium (81) avec une photoréserve ; exposer la photoréserve à la lumière et réaliser le processus de développement pour former un premier motif de réserve couvrant la partie du film en nitrure de silicium, où la partie restante du premier orifice doit être formée ;
- former le motif sur le film en nitrure de silicium (81) en utilisant le premier motif de réserve comme masque de manière à ne laisser le nitrure de silicium que là où la partie restante du premier orifice doit être formée, le premier motif de réserve étant plus petit que le premier orifice, et étant plus grand que la partie restante du premier orifice ;
- enduire la surface supérieure du film en silicium (42), sur lequel un motif doit être formé, et du film en nitrure de silicium (81) avec une réserve de faisceau électronique (44) ;
- exposer la réserve de faisceau électronique (44) à des faisceaux électroniques et réaliser un processus de développement pour former un deuxième motif de réserve (44) ayant un orifice qui ne définit que la partie de contour du premier orifice (82) et ayant un deuxième orifice (83) ;
- attaquer le film en silicium (42), sur lequel un motif doit être formé, en utilisant le deuxième motif de réserve (44) comme masque pour former la partie de contour du premier orifice (82) et le deuxième orifice (83) ;
- éliminer le deuxième motif de réserve (44), puis oxyder thermiquement la surface du film en silicium (42), sur lequel un motif doit être formé, pour ainsi former un film en oxyde de silicium (84) ;
- attaquer le film en nitrure de silicium (81) et le film en silicium (42), sur lequel un motif doit être formé, sous le film en nitrure de silicium (81), après l'oxydation thermique, pour ainsi former la partie restante du premier orifice, et
- éliminer le film en oxyde de silicium (84).

2. Procédé de formation de motif selon la revendication 1, dans lequel le deuxième motif de réserve (44) est formé en une fois en utilisant un seul système d'exposition à un faisceau électronique.
